Europäisches Patentamt

European Patent Office

Office européen des brevets

(19)

(11) Publication number: **0 372 682**
**A2**

(12) **EUROPEAN PATENT APPLICATION**

(21) Application number: **89308495.4**

(22) Date of filing: **22.08.89**

(51) Int. Cl.⁵: **G06F 15/60**

(30) Priority: **05.12.88 US 280171**

(43) Date of publication of application:
**13.06.90 Bulletin 90/24**

(84) Designated Contracting States:
**AT BE CH DE ES FR GB GR IT LI LU NL SE**

(71) Applicant: **DIGITAL EQUIPMENT CORPORATION**
**111 Powdermill Road**
**Maynard Massachusetts 01754-1418(US)**

(72) Inventor: **Kwag, Hye Keun**
**25 Oneida Road**
**Acton Massachusetts 01720(US)**
Inventor: **Quaynor, Nii Narku**
**Holly Lane**
**Shrewsbury Massachusetts(US)**

(74) Representative: **Goodman, Christopher et al**
**Eric Potter & Clarkson St. Mary's Court St.**
**Mary's Gate**
**Nottingham NG1 1LE(GB)**

(54) **System characterization method.**

(57) A method of evaluating the delays in processing information in a computer system comprising the steps of creating a model of the system, collecting statistics about the system and evaluating the model in terms of parameters derived from those statistics. In one embodiment of the invention a cluster of computers are evaluated in terms of the service times or delays for each component in the cluster. Statistical data from the operation of the cluster is transformed into a number of essential parameters which are then used to evaluate a queueing theory model of the cluster to determine the service times.

**FIG. 1**

## BACKGROUND OF THE INVENTION

A computer system is composed of a number of interacting components, all of which behave stochastically. This means that, although a component must respond to a command by the central processing unit (CPU), when it will respond cannot be determined. The amount of time between the issuing of a command by the CPU and the receiving of the response by the CPU indicating completion of execution of the command, is not a constant value, but instead varies around an average value with some probability distribution.

Consider for example a CPU issuing a read request to a disk controller. Once the disk controller receives the request it must determine the position of the read head and then move the head to the desired track. The amount of time it takes to do this is dependent upon the position of the head, i.e., over which track the head was positioned, when the command was received. Since, depending upon the application, the head is equally as likely to be over any track and since the track to which it must go is also equally likely one would expect the amount of time required to bring the head over the correct track would vary from zero (being over the correct track already) to some maximum (being over the furthest track from the one of interest). Once the head is over the correct track, there will be a delay as the head waits for the correct record to rotate past in order for the head to read the data. Again, one would expect that the amount of time required to bring the record under the head would vary from about zero, when the record rotates under the head just after the head reaches the correct track, to some maximum equal to the time required for a complete revolution, in the case where the record had just passed when the head reached the correct track.

Once the record is read, the controller may either be able to place the data on the bus, connecting the controller to the CPU, immediately or it may be forced to wait because of bus contention, that is, the bus being busy when the data is available.

Therefore, even in this simple example, the amount of time required to read data from a disk can vary from almost zero to some very long length of time equal to the summation of all the delays. These delays result from both contention for a resource such as a disk, and latency (the delay in response due to some physical limitation such as the finite rotational speed of the disk).

The computer system is so complex that the uncertainty in delays means that an accurate prediction of the performance of a computer system, from simply knowing the programs it will be running, is impossible. It should be apparent that this discussion applies equally to single CPU computers, multiprocessors (closely coupled systems of more than one CPU) and networks of multiple computers.

Since it is so difficult to determine how a computer system will perform with regard to a certain problem, the computer industry and users have developed a set a special programs to allow different computer systems to be compared. The programs, called benchmarks or synthetic workloads, perform a group of tasks that in some way reflect the way a computer will perform for all programs of the type. For example, some benchmarks are scientific calculations which are computation intensive, their providing an indication of CPU activity and as such indicates to some extent how other computation intensive programs will perform on a given system. Similarly, there are synthetic workload programs which simulate the input/output workloads, such as may be seen in input/output environments such as the banking industry.

Although benchmark programs provide a means for comparing computer systems at a broad level, they do not predict how a specific program will perform on a system or where problems will arise when the overall workload on the system is changed. Further, benchmarks provide no help in determining where a problem, such as a bottleneck that impairs system efficiency or through put, has arisen and so provide no help in attempting to correct it.

## Summary of the Invention

The invention provides a new and improved system comprising a method and apparatus for predicting usage and loading of a computer system in processing specific programs and work loads.

In brief summary, the new system comprises a means for gathering computer system statistics, a means for generating a mathematical model of the computer system and a means for evaluating the data using the computer system statistics.

Brief Description of the Drawing

This invention is pointed out with particularity in the appended claims. The above and further advantages of this invention may be better understood by referring to the following description taken in conjunction with the accompanying drawings, in which:

Fig. 1 is a block diagram of a computer system which includes a plurality of CPUs and disks;

Fig. 2 is a block diagram of the method of evaluating the complex system of Fig. 1;

Fig. 3 is a block diagram of a queue and its components.

Description of an Illustrative Embodiment

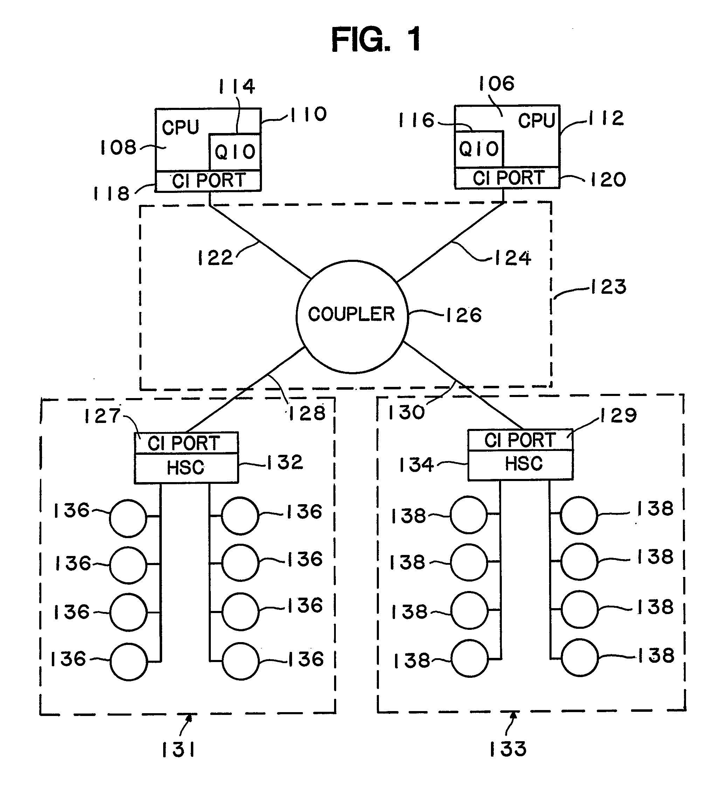

The invention will be described in terms of an illustrative computer system depicted in Fig. 1.

Fig. 1 depicts a group of computing components interconnected to form a cluster. The cluster, as depicted in Fig. 1, consists of two computers 110 and 112 and two disk units 131 and 133, each attached to a communications link, termed a computer interconnect (CI) segment 122, 124, 128 and 130. The CI segments 122, 124, 128 and 130 are in communication with each other section through a star topology coupler 126. Data moves from each of the CPUs 106 and 108 onto the CI segments 122 and 124 through an interface, termed a computer interconnect port (CI port) 118 and 120.

Each of the disk units 131 and 133 include disk controllers, termed hierarchical storage controllers (HSC) 132 and 134, which are attached to CI segments 128 and 130, respectively through a CI Port 127 and 129 respectively. The disk units 131 and 133 include disk storage devices 136 and 138 that are shared by both computers 110 and 112. The HSCs 132 and 134 control the passage of information between the CI segments 128 and 130, respectively, and the respective disk storage units disk 136 and 138.

When a computer 110 or 112, needs to send data over its respective CI segment 122 or 124, the CPU 106 or 108 places the data in an input/output queue (Q10) 114 or 116 respectively. From the QIO 114 or 116, the data passes to the respective CI port 118 or 120 for transmission over the CI segment.

Data to be sent over the CI segments 122 and 124 by the computers 110 or 112 is placed in an input-output queue (QIO) 114 or 116 respectively and passed to the CI Port 118 or 120 respectively. If data is already passing over any CI segment 122, 124, 128 or 130, the CI Port 118 or 120 waits until all CI segments 122, 124, 128 and 130 are idle before placing its data on its CI segment 122 or 124.

Because any computer 110 or 112 can access any disk storage device 136 and 138 on any disk unit 131 and 133, there may be contention between the computers 110 and 112 for a given disk storage device 136 or 138. The computer 110 or 112 which requests access to the disk storage device 136 or 138 second will have to wait until the disk storage device 136 or 138 becomes available. Further, even if the same disk 136 or 138 is not requested, there will still be contention if the computers 110 and 112 request access to different disk storage devices 136 or 138 on the same storage unit 131 or 133. This occurs because a disk unit takes a finite amount of time to service a request, and during that time, it cannot accept another request.

Finally, the various units including the computers 110 and 112 and the disk units 131 and 133 may contend for the communications link comprised of the various CI segments. If one unit 110, 112, 131 or 133 is using its CI segment 122, 124, 128 or 130 respectively to transmit information, any other device needing to transmit over its respective segment must wait until the transmitting until has finished before it can transmit.

Considering each component in more detail, in one embodiment the CI segments 122, 124, 128, and 130 are redundant four-coaxial two-path (two redundant paths for transmitting and the others for reception) serial links, which interconnect various cluster components. Each CI segment 122, 124, 128 and 130 is connected to the other segments through the star coupler 126 which is a passive device. The star coupler may support up to on the order of sixteen computers in one embodiment. The CI segments and the star coupler are collectively referred to as the CI 123. Data transmitted over a CI segment is manchester encoded a thus is self-clocking. Arbitration for the communications link is determined by the CI ports 118, 120, 127 and 129.

The CI Ports 118, 120, 127 and 129 provide the connection from the components 110, 112, 131 and 133 to respective CI segments 122, 124, 128 and 130. Each CI port 118, 120, 127 or 129 has two delay times associated with it that are specific to the computer with which the port is associated. When the CI 123 is lightly loaded (not carrying many messages) the shorter of the delay times is used, and the arbitration is by carrier sense multiple access (CSMA) contention. That is, if a CI Port 118, 120, 127 or 129 wishes to transmit, the Port 118, 120, 127 or 129 listens to the CI segment to which it is attached, 122, 124, 128 or 130 respectively, and if the communications link is not being used, the CI Port 118, 120, 127 or 129 waits an additional amount of time which is equal to its delay time. If the communications link is still unused, the CI Port transmits the data packet and waits for an acknowledgement. The receiving computer, upon receiving the data, transmits an acknowledgement without arbitrating further for the CI 123.

This CSMA arbitration scheme gives priority to the computers with the shortest delay times. However, in order to allow all computers equal access to the communications link when there are many messages being transmitted over the communications link, the Ports switch to the longer of the delay times and arbitrate by round-robin scheduling when the number of messages being sent per unit time exceeds a certain value. If a Port wins the arbitration, it will randomly select one of the two transmit paths (if both are functional) or the single functional path (if one has failed).

Another one of the components in the cluster is the hierarchical storage controllers (HSC) 132 and 134. Each HSC 132 and 134 can support up to 24 disk drives 136 and 138. Since all computers have access to all disks 136 and 138 belonging to the cluster, a lock manager is provided to keep several computers from accessing the same files on the disks 136 and 138 at the same time. The lock manager insures that while a file is being updated by one computer it cannot be read by another computer.

A lock manager is generally a complex program which is distributed over the computers of cluster. Strictly speaking, the lock manager controls the access to a shared system resource, which may be, for example, a file stored on a disk 136 or 138. The lock manager allows processes to share a resource and synchronize access to that resource. To do this, a computer can request to hold or to release a lock. Depending upon the type of lock (e.g. exclusive access, protected read, etc.), the computer not holding the lock may or may not be able to access the resource. For example, if the lock is for exclusive access, then the only computer that can access the resource is the computer holding the lock; if the lock is for a protected read, another computer can read, but not write, the resource.

The lock manager is distributed across the computers of the cluster so that, if the computer holding a lock should fail, the lock manager can correct the problem and allow other computers in the cluster access to the locked resource. This is done by allocating each resource to a master computer which grants locks to or removes locks from the resource. A directory links the resource and its master computer. When a computer wishes to lock a resource, it sends a request to the directory of the resource which then returns the name of the master computer for that resource. The computer can then request a lock for the resource from that master computer. The lock and unlock requests are messages sent across the CI 123. If a computer requests a lock on a resource that already has another incompatible lock held by another computer, the new request is queued by the master computer until such time that the resource is unlocked or a compatible lock is on the resource. For example, if one computer requests a protected read lock on a resource which already has an exclusive access lock on it held by another computer, the request for the protected read lock would be placed in a queue until the exclusive access lock is removed. The important point of this is that the locking scheme of the cluster always contributes an unpredictable delay to the total delay in the system.

Although the invention may be used in connection with an analysis other systems may have components which behave similarly and thus the invention may, with suitable variation be used in connection with those systems. A local area network is an example of such a system. In a local area network, for example EthernetTM, computers are connected together by a communication line arbitrated for by CSMA. As in the CI 123, a computer wishing to transmit a message listens to the line and waits until there are no messages being transmitted on the line. When the line is clear, the computer may begin to transmit. Because only one computer can transmit on the line at a time, there is contention for the line, and this results in delays.

A computer wishing to transmit a message over the network must communicate with the network through an interface port, termed a network interconnect port (NI Port). Because multiple programs on the same computer may be requesting access to the network, the NI Port will queue-up messages for transmission, leading to a delay.

A third source of delay in the Ethernet TM is the protocol which governs the functioning of the network. Since it is necessary to have reliable communications over the network, the protocol for communicating over the network includes messages and acknowledgements, both of which contend for access to the network.

Another type of system with delays similar to a cluster is the multiprocessor system. A multiprocessor system typically consists of a number of CPUs each connected to a single bus. Additionally, the system typically has a memory also connected to the bus which is available to all the CPUs over the bus. Again, here are two resources, namely the bus and the memory for which the CPUs will be in contention and to

4

which access must be controlled.

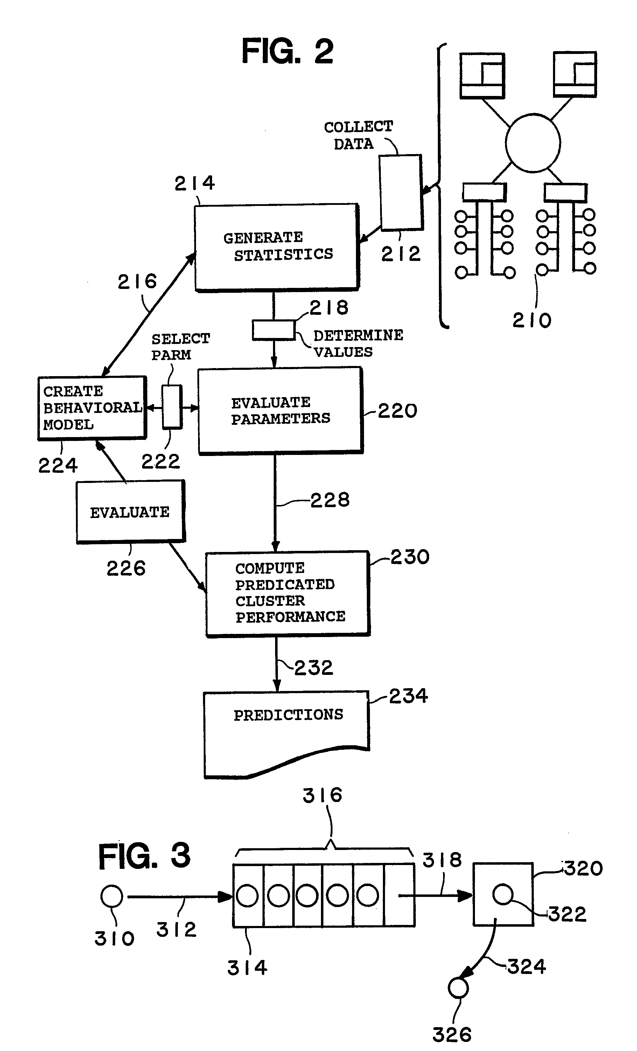

In each of these cases, it would be beneficial to be able to predict the performance of the system. Preferably, the method of predicting performance would be sensitive the shifting workloads of the system. What is required therefore is a method of analyzing the system such that the various delays can be characterized as a function of the number of transactions occurring on the system. A method of doing this is to study the system in the following way. Referring to Fig. 2., a system 210, to be studied is allowed to operate normally, and data is collected (step 212) about its performance under normal workloads. The data collected is used to generate statistics (step 214) which describe the various parts (e.g. I/O, CPU utilization, etc.) of the system. The statistics are used to create a model (step 224) describing the behavior of the system. From the model certain parameters are selected (step 222) as being descriptive of the system (e.g. I/O operations per process, number of processes per sec, etc.). From the statistics, values necessary for the evaluation of the parameters are determined (step 218) and the parameters evaluated (step 220) (e.g. through curve fitting, time averaging, etc.).

The performance of the cluster is then calculated (step 230) using the parameters evaluated and the model evaluated for accuracy (step 226) and modified if necessary. If the model is accurate, the model is used to generate predictions 234 as to system behavior under a variety of loading calculations.

To explain how this process works with a given system, consider the analysis of the cluster just described.

Each computer (Fig. 1) 110 and 112 of the cluster records, during its processing of one or more programs, data concerning each process or program that the computer executes. The data which are recorded by a processor and which are useful in characterizing the activity of the cluster include such information as the image activation rate (F) which is the number of images being started per unit time; the remote locking rate for incoming locks (R) which is the rate at which lock requests are coming into a lock master per unit time; the local locking rate (O) which is the rate at which a lock master is setting its own locks on a resource; the I/O rate (I) which is the number of I/O operations per unit time; and the utilization (U) which is how much of the computing power of the processor is being used in terms of the fraction of the total number of possible computer operations. Since the image activation data, the I/O rate and the utilization are recorded by processor, image and data record each is indexed by processor (p), image (m) and data record (r).

Because the locks are recorded by processor and data record, the locking rates are indexed by processor (p) and data record (r).

The type of processor provides the following information in the form of constants:

$V_p$ relative processing power of the processor (p)

$n_p$ number of processors in one computer

Additionally, the configuration of the cluster provides the following data which are in the form of constants:

N number of processors in the cluster

M total number of images in the cluster

b kilo-instructions for each lock that is set by a lock manager on it's own resource (local lock)

d kilo-instructions for each lock that is set by a lock manager due to a lock request by another computer (remote lock)

e number of messages which must be sent across the communications link for each lock request that is made by a computer to a lock manager (remote lock)

f normalizing rate for processing power of processor

g remote lock message processing time which is the amount of time required by a lock manager to process a lock request from another computer

In one embodiment, the processing power, Vp, is relative to that of a VAX 11/780 manufactured by Digital Equipment Corporation, assignee of this invention.

In one embodiment, the values for the constants for a typical cluster comprised of components manufactured by Digital Equipment Corporation have been determined to be:

| | |
|---|---|
| Kilo-instructions per local lock | .5<b<z |
| Kilo-instructions per remote lock | .1<d<.5 |
| Remote lock messages per remote incoming lock | 2<e<3 |
| Normalizing rate | 3<f< 4 |
| Remote lock message processing time | .1<g<.4 |

From this data a series of parameters can be determined which are essential for workload characterization. The parameters are determined on the basis of a program class, which is an arbitrary characterization of the program in terms of whether it is computationally intensive, I/O intensive, etc. These parameters are considered essential because they are needed to evaluate the model of the system. Some of these parameters are given in terms of transactions, which is the computation of one image, or group of images.

The essential parameters, are:

$K_c$ Kilo-instructions per transaction in class c.

$B_{pc}$ Probability that transaction in class c will be allocated to processor p.

$L_c$ Locks per transaction in a class c

$A_c$ Expected interarrival time, its rate of image activations for a class c (in seconds)

$T_c$ Total I/O operations per transaction in a class (c)

$S_c$ Average I/O size for a class (c) (in Kilobytes per I/O operation)

One way in which these values are determined is through consideration of the following.

Since the data for the image activation rate (F), are collected and indexed based on the processor, image and data records, that is, the collected data may be represented as Fp,m,r, the total image activation rate for a given processor for a given class in the sum of the image activation rates over the images in the class and over the data records, that is:

$$F_{p,c} = \sum_{r=1}^{R} \sum_{m \in J_c} F_{p,m,r}$$

Where $J_c$ is the set of images for class (c), and (R) is the total number of records for the data collection period.

Similarly, the I/O rate for a processor (p), class (c) is computed by:

$$I_{p,c} = \sum_{r=1}^{R} \sum_{m \in J_c} I_{p,m,r}$$

The number of operations I/O per transaction for a class (c) is computed by

$$TI_c = \frac{\sum_{p=1}^{N} I_{p,c}}{\sum_{p=1}^{N} F_{p,c}} \quad \text{for all (c)}$$

The ratio of I/O operations for a processor, image and data record normalized over the I/O operations for all the images is computed by:

$$W_{p,m,r} = \frac{I_{p,m,r}}{\sum_{m=1}^{M} I_{p,m,r}}$$

The remote locking rate for incoming locks for processor (p) and a class (c) is computed as:

$$R1_{p,c} = \sum_{m \in J_c} \sum_{r=1}^{R} \frac{(R1_{p,r})(W_{p,m,r})}{R}$$

The local locking rate for a processor (p), and a class (c) is calculated by:

$$O_{p,c} = \sum_{m \in J_c} \sum_{r=1}^{R} \frac{(O_{p,r})(W_{p,m,r})}{R}$$

for all (p), (c).

The utilization of a processor (p) for a class (c) is calculated by :

R

$$U_{p,c} = \sum_{r=1}^{R} \sum_{m \in J_c} U_{p,m,r}$$

From these parameters the kilo-instructions per I/O for a processor (p), and a class (c) ($KI_{p,c}$) can be calculated by using the system constants:

$$KI_{pc} = \frac{((U_{p,c})(n_p)(v_p) - (b)(O_{p,c}) - (d + (e)(f)(g))(R1_{p,c}))}{I_{p,c}}$$

Once this is determined, the kilo-instructions per I/O for class (c) can be derived by :

$$KI_c = (N \frac{1}{\sum_{p=1} Ip,c}) \; (\sum_{p=1}^{N} (KI_{p,c})(I_{p,c})) \; \text{for all (c)}$$

Once this is calculated, the essential parameter kilo-instructions per transaction ($K_c$) can be derived:

$K_c = KI_c TI_c$ for all (c).

The essential parameter branching probability ($B_{p,c}$) can be calculated directly by:

$$B_{p,c} = \frac{(U_{p,c})(N_p)(V_p)}{\sum_{p=1}^{N} (U_{p,c})(N_p)(V_p)} \quad \text{for all (c), (p)}$$

The essential parameter expected interarrival time ($A_c$) for images of class (c) is calculated by:

$$A_c = \frac{1}{\sum_{p=1}^{N} F_{p,c}} \quad \text{for all (c), (p)}$$

While the I/O's per transaction is given by:

$$T_c = \frac{\sum\limits_{p=1}^{N} I_{p,c}}{\sum\limits_{p=1}^{N} F_{p,c}} \quad \text{for all (c), (p)}$$

The remote locking rate for outgoing locks $R_{p,c}$ is given by:

$$R_{p,c} = \sum_{m \epsilon J_c} \sum_{r=1} \left(\frac{R_{p,r} \; W_{p,r}}{R}\right) \quad \text{for all (c), (p)}$$

and from this the essential parameter locks per transaction ($L_c$) can be determined.

$$L_c = \frac{\sum\limits_{p=1}^{N} O_{p,c} + \sum\limits_{p=1}^{N} R_{p,c}}{\sum\limits_{p=1}^{N} F_{p,c}} \quad \text{for all (c), (p)}$$

Finally the average I/O size ($S_c$) is determined by:

$$S_c = \sum_{p=1}^{N} \sum_{m \epsilon J_c} \sum_{r=1} \left(\frac{(S_{p,r}) \; (W_{p,r,m})}{R}\right) \quad \text{for all (c), (p)}$$

It has been found that it is possible to characterize the cluster using the seven cluster constants and these six essential parameters which are derived from five measured quantities.

The aim then is to create models which characterize the cluster in terms of these essential parameters and constants. The characterization of a system, such as a cluster, in terms of the service times of the components of the system is a reasonable way to understand how processes are delayed within the system. A service time is a queueing theory concept which describes the amount of time it takes for a request to be acted upon by a device. An example of this is the amount of time it takes for a read request to be acted upon by a disk drive.

More specifically, referring to Fig. 3, since each server 320 can only process one request 322 at a time, additional requests 310 enter 312 a queue 316 at the end of the queue 314. Requests are removed from the front of the queue 318 as each prior request 326 is serviced 324. If requests enter the queue faster than the requests are serviced, the queue length grows and the service time increases. The service time is therefore not a fixed number but varies according to how the new requests arrive.

To accommodate a queueing theory model, models are provided for the components of the cluster depicted in Fig. 1, in order to determine service times of the: CPU ($EST_{cpu}$), QIO ($T_{QIO}$), CI port ($T_{port}$), CI bus service time ($T_{CI}$), and the HSC ($T_{HSC}$) as well as the average disk I/O processing time ($T_{I/O}$). Each of the essential parameters appear in at least one of the service time models. For example, the, essential parameter Kilo instruction per transaction ($K_c$) is used for the CPU service time calculations, but the essential parameter locks per transaction ($L_c$) is used in the service time models for the QIO, CI port and CI bus. The essential parameter I/O size per transaction ($S_c$) is used in the QIO, CI port, CI bus and HSC service time models.

The first service time that will be determined is the CPU service time. The CPU service time is a

EP 0 372 682 A2

function of the utilization level of the processor. Service times vary widely if the processor is lightly utilized, but become more predictable as the CPU becomes busier. This is reasonable since a lightly utilized processor may have no request in the queue one moment and so have a low service time but may have several requests arrive a short time later and so have a longer service time. On the other hand, a heavily used processor will have a queue of requests associated with it that will not vary much in length and so will have a service time which tends toward an average value. The reason this is true is that the queueing model for the processor is referred to as an M/G/1 model. The notation means that the interarrival times (M) are distributes exponentially, that the service time distribution (G) is general and that (1) means there is only one server. With this type of system, such things as the variation in service times can be determined.

The variation in CPU service time can be characterized by a coefficient of variation (CV). The coefficient of variation is a measure of spread of the distribution of service times. The higher the CV, the more the distribution is spread. The CV is less than or equal to one if the CPU utilization is greater than a predetermined value utilization threshold; and greater than one if the utilization is less than or equal to the utilization threshold.

Specifically, the coefficient of variation is given by:
CV = K-(c)(U) where u is the utilization, and (k) and (c) are constants. In one embodiment of the cluster the constants have the ranges 2<k<4 and 2<=c<=4.

The expected service time of a CPU will be proportional to the number of instructions it has to execute for each transaction and inversely proportional to the CPU's powers, which is a measure of the number of instructions the CPU can execute per second. In terms of the essential parameter, $(K_c)$, the number of instructions per transaction and the constant $(V_p)$ the processor power, the expected service time $(EST_{CPU})$ for the CPU is given by:

$$EST_{CPU} = \frac{K_c}{V_p}$$

The second service time to be calculated is the HSC service time. The hierarchical storage device controller (HSC) is an intelligent device which controls access to the disks. It would be expected that the service time for the HSC will be a function of the size of the I/O operation to be serviced and a function of the power of the processor in the HSC. The service time is therefore dependent upon the essential parameter $(S_c)$, the average I/O size. Because the HSC 132 buffers data, the (HSC) service times obey the following relationship. If the I/O consists of (k) blocks of data then if (k <= 8)
$T_{HSC} = H$
where H is a constant whose value depends upon HSC type and I/O size. If (k>8) then:
$T_{HSC} = (k)(512 / (A + B(k-C))$
where A,B, and C are also constants which may vary according to HSC type and I/O size. In one embodiment the constants are found to take on the following values:
.001<H<.003 (sec)
$10^6<A<=4x10^6$
$10^3<B<5x10^4$
8<c<60

Although the disk 136 is controlled by the HSC 362, the disk service time is treated independently from the HSC service time, reflects the physical limitations of the disk.

The time for a disk 136 to service a request will be the sum of: the time it takes the head to be positioned over the requested track, termed the seek time; the time it takes for the data to rotate under the head, termed the latency time; the time it takes for the head to sense its location on a track; and the time it takes to transfer the data from the disk to the HSC.

In addition to the HSC service time and the disk service time, the average time for processing an I/O request, for example from a CPU to an HSC will also include the delays for each component between the CPU and the HSC. To calculate this total I/O service time it is first necessary to calculate service times for the other components between the CPU and the HSC, which include the CI Port, CI and QIO.

The third service time to be calculated is that of the CI Port. To determine the service time for the CI Port, a consideration of the details of how messages pass through the CI port to and from the CI is required.

When a disk I/O request is sent, there are two types of messages which pass through the CI Port. One

9

type are data messages such as I/O requests and the second type are the remote lock messages when control access to a disk. The average total number of messages for each disk I/O that pass through the CI port is the total number of data messages plus the total number of remote lock messages.

That is:

ATNM = 2 + (2) (number of remote lock messages)

The mean processing time (MPT) to process, each message is a function of the computing power of the CI port. The total processing time for the messages passing through the CI port therefore is given by:

$T_{port\text{-}message}$ = (ATNM)(MPT)

Besides these messages, the CI port also passes disk blocks of data and confirmation messages. A confirmation message is required after a specified number of disk blocks have been sent. The total number of confirmation messages (N), therefore depends on the essential parameters ($S_c$), the average I/O size; and ($T_c$) the total number of I/O operations per transaction. If (k) blocks of data are transmitted, (N) is given by:

$$N = \left( \frac{k \cdot A}{4} \right) + 1$$

So the total time required to process (K) blocks of data and (N) confirmation messages is:

$T_{port\text{-}data}$ = k(BPT) + N(TCNF)

where BPT is the data processing time and TCFN is the confirmation processing time. In one particular embodiment in which the CI port is a CI 780 or a CIBCA sold by Digital Equipment Corporation, the BPT, TCFN and MPT are given in microseconds by

|  | MPT | BPT | TCFN |
|---|---|---|---|
| CI780 | 20<MPT<40 | 100<BPT<200 | 250<TCNF<350 |
| CIBCA | 40<MPT<70 | 200<BPT<400 | 500<TCNF<700 |

Once data or control messages pass through the CI port, the next service time of interest, the next on the list, is for the CI communications link itself. The CI service time includes the arbitration time for the CI, the time required to send an acknowledgement, the time required to send lock messages, the time to send multiple blocks of disk data, and the time required to retry a transmission that has failed. This service time will therefore depend upon the essential parameters, ($S_c$), the average I/O size; ($T_c$), the total number of I/O operations per transaction and ($L_c$) the number of locks per transaction.

The average message transfer time per disk I/O if the time to transfer one message is (MT) is given by:

$T_{CI\text{-}msg}$ = (2 + number of remote lock messages) (MT)

The average time to send (k) blocks of data when the time to send one block is (DT) is:

$T_{CI\text{-}data}$ = k (DT)

Thus, the total time to transfer data across the CI is the sum of the timer required to send the messages required for a disk I/O operator, plus the time required to transfer the data by:

$T_{CI}$ = $T_{CI\text{-}msg}$ + $T_{CI\text{-}data}$

This expression does not, however, take into account the fact that some messages will fail to reach their destination and must be resent. Bringing this retry fraction into account, the CI service time becomes

$T_{CI}$ = ($T_{CI\text{-}lock}$ + $T_{CI\text{-}data}$)(1 + retry-fraction)

The final service time to be calculated is the one for handling disk I/O request is the QIO service time. When a processor wishes to transmit or receive data, it places a request on an I/O queue. It happens that the amount of service time is dependent upon whether the message entering the I/O request queue is a lock message. If the message is not a lock message, the amount of time is a function of its size, as indicated by the essential parameter ($S_c$), the I/O size.

If the I/O size in less than or equal to two Kilobytes, then the time to process a non-lock QIO is given by:

$$T_{QIO-nlock} = \text{(time to process the blocks by a \underline{standard processor)}} \text{(amount of power in the processor relative to the standard processor)}$$

If the I/O size is between 2 and 32 Kilobytes, the time to process a non-lock QIO is:

$$T_{QIO-nlock} = \text{(time to process the blocks by a} \underline{\text{standard processor)}} + (SL) (S_c - 2) \text{(amount of power in the processor relative to the standard processor)}$$

where (SL) is a constant. In one embodiment (SL) ranges from 50 to 70 and the time to process a block of data on a standard processor ranges from 6 to 2 milliseconds.

To calculate the time to process lock messages, it must be remembered that the number of remote locks messages (NRLM) is a function of the number of remote locks which is in turn a function of the number of locks per transaction, $L_c$, an essential parameter.

Specifically:

(NRLM) = (NRL)(LM)

where (LM) is the number of messages per lock. The QIO service time to process the lock messages then is given by:

$T_{QIO-lock} = \underline{(NRLM)(LT)}$

processing power of the processor where (LT) is the processing time for a remote lock message. In one embodiment, the number of messages per lock, LM, ranges from 2 to 3 and the processing time LT ranges from .5 to 1 milliseconds.

Once all these service times are determined, the total I/O service time for the system can be determined as the sum of the individual component service times.

$T_{I/O} = T_{QIO-lock} + T_{QIO-data} + T_{port-lock} + T_{port-data} + T_{CI} + T_{HSC} + T_{disk}$

The knowledge of the service times of each of the components and the service time for the system completely characterizes the system. These service times are good metrics as to how the system will behave under a given set of loading conditions. Having this model allows one to vary the loading conditions and determine how the service times change, thereby helping to determine the location of bottlenecks and suggesting a way to eliminate them.

One skilled in the art would understand that the preceding analysis done for a cluster could be done for any system. What is required is a determination of the essential parameters of the system and the collection of data to evaluate those parameters.

Having shown the preferred embodiment, those skilled in the art will realize many variations are possible which will still be within the scope and spirit of the claimed invention. Therefore, it is the intention to limit the invention only as indicated by the scope of the claims.

## Claims

1. A system for modeling a data processing system having a plurality of CPUs, a plurality of peripheral devices and a communications link interconnecting the CPUs and the devices, said modeling system comprising:
a means for gathering statistics about the data processing system;
a means for describing a mathematical model for each component of the data processing system; and
a means for evaluating said models using the statistical data from said statistical data gathering means.

2. A system for predicting the performance of a data processing system having a plurality of CPUs, a plurality of peripheral devices and a communication link inter-connecting the CPUs and the devices, said predicting system comprising:

a means for collecting statistical data about the data processing system;

a means for establishing a set of essential parameters from said statistical data;

a means for evaluating said essential parameters using said statistical data;

a means for mathematically modeling each component of said data processing system;

a means for processing said mathematical model using said essential parameters;

a means for evaluating said model for system load of interest.

3. A system for predicting the performance of a VAX cluster having a plurality of CPUs, a plurality of disk controllers, a plurality of computer interconnect segments, each connected to a CPU or disk controller, and a star coupler connecting said interconnect segments comprising:

a means for collecting statistical data about each image running on the CPUs of the data processing system;

a means for determining from the statistical data into a set of essential parameters;

a means for evaluating said essential parameters using said statistical data;

a means of modeling each component in said cluster in terms of said essential parameters;

a means of processing said models using said parameters.

# FIG. 1

# FIG. 2

COLLECT DATA

214

216

GENERATE STATISTICS

212

210

218

DETERMINE VALUES

SELECT PARM

CREATE BEHAVIORAL MODEL

EVALUATE PARAMETERS

220

224

222

EVALUATE

226

228

COMPUTE PREDICATED CLUSTER PERFORMANCE

230

232

PREDICTIONS

234

# FIG. 3

316

318

320

310

312

314

322

324

326

Neu eingereicht / Newly filed
· Nouvellement déposé